# EUROPÄISCHE PATENTANMELDUNG

(11) **EP 1 154 492 A2**
(43) Veröffentlichungstag der Anmeldung: **14.11.2001**
(21) Anmeldenummer: 01110647.3
(22) Anmeldetag: 02.05.2001
(51) Int. Cl.: H01L 31/048, H01L 31/18

(54) **Verfahren zum Herstellen eines Solarmoduls für ein Fahrzeug**

(30) Priorität: 11.05.2000 DE 10022626
(71) Anmelder: Webasto Vehicle Systems International GmbH, 82131 Stockdorf (DE)
(72) Erfinder: Bergmiller, Alexander, 86152 Augsburg (DE)
(74) Vertreter: Wiese, Gerhard

(57) **Zusammenfassung**

Die Erfindung betrifft ein Verfahren zum Herstellen eines Solarmoduls für ein Fahrzeug, wobei Verbindungselemente (18) zum elektrischen Verbinden von Solarzellen (14, 16) in einer vorgegebenen Anordnung auf einem Trägerelement (12) für die Solarzellen (14, 16) positioniert werden, die Verbindungselemente (18) positionsfest mit dem Trägerelement (12) verbunden werden, eine erste Laminierungsfolie (22) auf dem Trägerelement (12) positioniert wird, die Solarzellen auf der ersten Laminierungsfolie (22) positioniert und in elektrischem Kontakt (20) positionsfest mit den Verbindungselementen (18) verbunden werden, eine zweite Laminierungsfolie (24) auf den Solarzellen (14, 16), den Verbindungselementen (18) und dem Trägerelement (12) positioniert wird; und die Struktur einem Laminierungsprozess unterzogen wird. Bei einer Abwandlung wird vor dem Laminieren keine positionsfeste Verbindung zwischen den Verbindungselementen und den Solarzellen hergestellt, jedoch wird ein dauerhafter elektrischer Kontakt zwischen den Verbindungselementen und den Solarzellen mittels des Laminierungsprozess sichergestellt.

## Beschreibung

Die vorliegende Erfindung betrifft ein Verfahren zum Herstellen eines Solarmoduls für ein Fahrzeug, insbesondere für einen Solardeckel.

Bei einem im Hause der Anmelderin bekannten Verfahren zum Herstellen eines Solardeckels für ein Kraftfahrzeug vom Typ Audi C5 werden Solarzellenstrings in einer Positionierungsvorrichtung positioniert und mit entsprechenden positionierten Zellenverbindern verlötet. Anschließend werden die Zellenverbinder an bestimmten Stellen voneinander getrennt und in die entsprechenden Zwischenräume werden Widerstände als Abstandshalter eingelötet. Der so erhaltene Solarzellenverbund wird auf einer Glasscheibe des Deckels positioniert und mittels Klebestreifen oder einem Glasvlies gegen Verrutschen fixiert. Anschließend wird die so fixierte Struktur einem Laminierungsprozess mit Schmelzklebefolien unterzogen. Nachteilig bei diesem Verfahren ist die aufwendige Fertigung in vielen Teilschritten, der notwendige Einsatz von zusätzlichen Hilfsmitteln gegen das Verrutschen der Strings während des Laminierens sowie die schwierige Positionierung des gesamten Solarzellenverbunds auf der Glasscheibe, wobei große Toleranzen, die aus der Summierung vieler Einzeltoleranzen resultieren, auftreten.

Es ist Aufgabe der vorliegenden Erfindung, ein Verfahren zum Herstellen eines Solarmoduls für ein Fahrzeug, insbesondere für ein Fahrzeugdach, zu schaffen, welches auf möglichst einfache Weise eine exakte Positionierung der Solarzellen in dem Solarmodul erlaubt.

Diese Aufgabe wird erfindungsgemäß gelöst durch ein Verfahren gemäß Anspruch 1 bzw. ein Verfahren gemäß Anspruch 3. Bei diesen Lösungen ist vorteilhaft, dass durch das direkte Positionieren und Fixieren der Verbindungselemente eine Verringerung der Toleranzen erzielt wird und eine externe Fixierung der Verbindungselemente während des Laminierungsvorgangs nicht erforderlich ist.

Bei der Lösung gemäß Anspruch 1 ist besonders vorteilhaft, dass auch für die Solarzellen selbst keine zusätzlichen Fixierungsmittel, wie Klebestreifen oder Glasvlies, während des Laminierungsvorgangs erforderlich sind. Ferner besteht keine Gefahr des Verrutschens der Solarzellen während des Laminierungsvorgangs. Auch sind keine Abstandshalter oder ähnliches erforderlich, um eine exakte Positionierung zu gewährleisten.

Bei der Lösung gemäß Anspruch 3 ist besonders vorteilhaft, dass vor dem Laminierungsprozess keine feste Verbindung zwischen den Verbindungselementen und den Solarzellen, beispielsweise mittels Verlöten, hergestellt werden muss.

Bevorzugte weitere Ausgestaltungen der Erfindung ergeben sich aus den Unteransprüchen.

Nachfolgend ist die Erfindung anhand der beigefügten Zeichnungen beispielhaft näher erläutert, wobei:
- Fig. 1: eine Ansicht von unten auf einen erfindungsgemäßen Solardeckel während der Herstellung, und
- Fig. 2: einen erfindungsgemäßen Solardeckel in Schnittansicht nach der Herstellung zeigt.

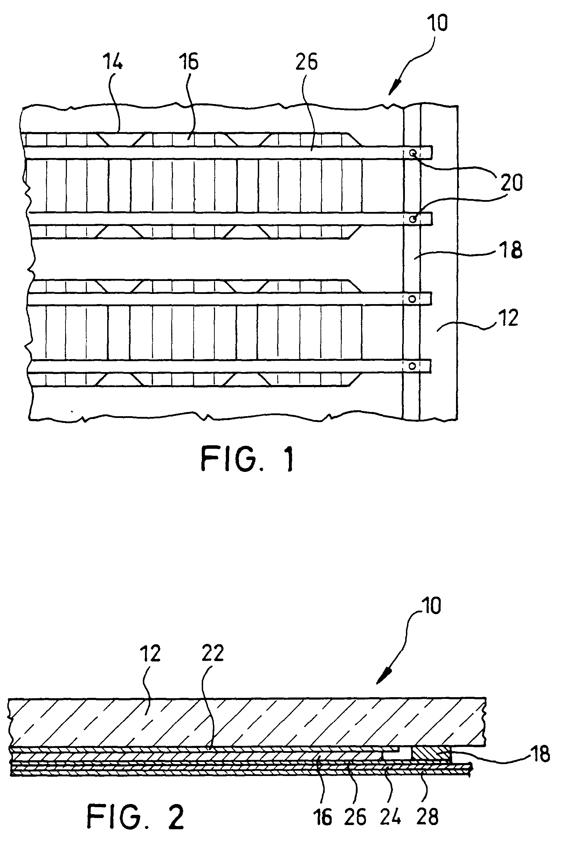

Die Figuren 1 und 2 zeigen schematisch einen Solardeckel 10, der als Träger eine transparente Deckelscheibe 12 aus Glas sowie mehrere Solarzellenstrings 14 umfasst, die jeweils aus mehreren elektrisch miteinander verbundenen einzelnen Solarzellen 16 bestehen. Verbindungselemente 18 sind als Zellenverbinder vorgesehen, um die Solarzellenstrings 14 elektrisch zu kontaktieren bzw. miteinander zu verbinden, wobei der elektrische Kontakt über Lötstellen 20 hergestellt wird. Die Solarzellenstrings 14 mit den Solarzellen 16 sind mittels einer ersten transparenten Schmelzklebefolie 22 sowie einer zweiten Schmelzklebefolie 24, die vorzugsweise aus EVA gefertigt sind, mit dem Glasdeckel 12 laminiert.

Die Herstellung eines solchen Solardeckels 10 kann auf folgende Weise erfolgen. Zunächst werden die Verbindungselemente 18 unter Verwendung einer Schablone in vorgegebener Anordnung auf der Glasscheibe 12, die als Träger dient, positioniert und in dieser Stellung positionsfest an der Glasscheibe 12 befestigt, wobei dies vorzugsweise dadurch erfolgt, dass vorgefertigte Teilstücke der Verbindungselemente 18 einseitig selbstklebend ausgebildet sind und auf diese Weise eine Klebeverbindung zwischen den Verbindungselementen 18 und dem Glasdeckel 12 hergestellt wird. Anschließend wird die erste Schmelzklebefolie 22 auf den Glasdeckel 12 aufgelegt, wobei die von den Verbindungselementen 18 eingenommenen Bereiche ausgespart bleiben. Die Solarzellenstrings 14 bzw. Kontakte 26 werden nun direkt mit den aufgeklebten Verbindungselementen 18 verlötet, um die Lötverbindungen 20 zu bilden. Auf diese Weise wird einerseits ein elektrischer Kontakt und andererseits eine mechanische Fixierung der Solarzellenstrings 14 bezüglich der Zellenverbinder 18 und, über deren Fixierung bezüglich der Glasscheibe 12, auch eine Fixierung der Solarzellenstrings 14 bezüglich der Glasscheibe 12 erzielt. Anschließend wird die zweite Schmelzklebefolie 24 auf die Solarzellenstrings 14 und die Verbindungselemente 18 aufgelegt. Auf die zweite Schmelzklebefolie 24 folgt schließlich eine Deckfolie 28, womit der Laminierungsvorgang seinen Abschluss findet. Die eigentliche Laminierung der Schmelzklebefolien 22 und 24 erfolgt in der üblichen Weise.

Durch das direkte Fixieren der Verbindungselemente 18 an der Glasscheibe 12 und das Fixieren der Solarzellenstrings 14 mittels der Lötstellen 20 an den fixierten Verbindungselementen 18 kann eine sonst erforderliche externe Fixierung dieser Komponenten während des Laminierungsvorgangs entfallen, wodurch sich der Herstellungsprozess erheblich vereinfacht. Ferner können auch die Toleranzen wesentlich geringer gehalten werden.

Bei einer Abwandlung des beschriebenen Herstellungsverfahrens wird auf die Lötverbindung zwischen den Solarzellenstrings 14 und den Verbindungselementen 18 verzichtet. In diesem Fall werden die Kontakte 26 zu den Solarzellenstrings 14 lediglich vor dem Laminierungsvorgang auf die Verbindungselemente 18 in elektrischem Kontakt aufgelegt. Da jedoch in diesem Fall keine mechanische Verbindung vor dem Laminierungsvorgang zwischen den Solarzellenstrings 14 und den Verbindungselementen 18 erfolgt, muss während des Laminierungsvorgangs eine externe Fixierung, beispielsweise mittels Klebebändern oder eines Glasvlies, erfolgen. Die dauerhafte elektrische Verbindung zwischen den Kontakten 26 und den Verbindungselementen 18 erfolgt dann durch ein Verpressen während bzw. als Resultat des Laminierungsvorgangs.

## Patentansprüche

1. Verfahren zum Herstellen eines Solarmoduls für ein Fahrzeug, wobei:
Verbindungselemente (18) zum elektrischen Verbinden von Solarzellen (14, 16) in einer vorgegebenen Anordnung auf einem Trägerelement (12) für die Solarzellen (14, 16) positioniert werden,
die Verbindungselemente (18) positionsfest mit dem Trägerelement (12) verbunden werden,
eine erste Laminierungsfolie (22) auf dem Trägerelement (12) positioniert wird,
die Solarzellen (14, 16) auf der ersten Laminierungsfolie (22) positioniert und in elektrischem Kontakt (20) positionsfest mit den Verbindungselementen (18) verbunden werden,
eine zweite Laminierungsfolie (24) auf den Solarzellen, den Verbindungselementen (18) und dem Trägerelement (12) positioniert wird; und
die Struktur einem Laminierungsprozess unterzogen wird.

2. Verfahren nach Anspruch 1, **dadurch gekennzeichnet, dass** die Solarzellen (14, 16) mit den Verbindungselementen (18) verlötet werden.

3. Verfahren zum Herstellen eines Solarmoduls für ein Fahrzeug, wobei:
Verbindungselemente (18) zum elektrischen Verbinden von Solarzellen (14, 16) in einer vorgegebenen Anordnung auf einem Trägerelement (12) für die Solarzellen (14, 16) positioniert werden,
die Verbindungselemente (18) positionsfest mit dem Trägerelement (12) verbunden werden,
eine erste Laminierungsfolie (22) auf dem Trägerelement (12) positioniert wird,
die Solarzellen (14, 16) auf einer ersten Laminierungsfolie (22) positioniert und in elektrischen Kontakt mit den Verbindungselementen (18) gebracht werden,
eine zweite Laminierungsfolie (24) auf den Solarzellen (14, 16), den Verbindungselementen (18) und dem Trägerelement (12) positioniert wird; und
die Struktur einem Laminierungsprozess unterzogen wird, welcher die Struktur derart verbindet, dass ein dauerhafter elektrischer Kontakt zwischen den Verbindungselementen (18) und den Solarzellen (14, 16) sichergestellt wird.

4. Verfahren nach Anspruch 3, **dadurch gekennzeichnet, dass** die Verbindungselemente (18) durch den Laminierungsprozess mit den Solarzellen (14, 16) verpresst werden.

5. Verfahren nach einem der vorhergehende Ansprüche, **dadurch gekennzeichnet, dass** das Positionieren der Verbindungselemente (18) in der vorgegebenen Anordnung mittels einer Schablone erfolgt.

6. Verfahren nach einem der vorhergehende Ansprüche, **dadurch gekennzeichnet, dass** das positionsfeste Verbinden der Verbindungselemente (18) mit dem Trägerelement (12) mittels einer Klebeverbindung erfolgt.

7. Verfahren nach Anspruch 6, **dadurch gekennzeichnet, dass** die Verbindungselemente (18) mindestens in Teilbereichen einseitig selbstklebend ausgebildet sind.

8. Verfahren nach einem der vorhergehende Ansprüche, **dadurch gekennzeichnet, dass** es sich bei dem Trägerelement um eine Glasscheibe (12) handelt.

9. Verfahren nach Anspruch 8, **dadurch gekennzeichnet, dass** das Trägerelement (12) einen Teil eines Deckels (10) für eine Dachöffnung bildet.

10. Verfahren nach einem der vorhergehende Ansprüche, **dadurch gekennzeichnet, dass** es sich bei den Laminierungsfolien (22, 24) um EVA-Folien handelt.

11. Verfahren nach einem der vorhergehende Ansprüche, **dadurch gekennzeichnet, dass** die Solarzellen (16) als Strings (14) gruppiert sind und die Verbindungselemente (18) zum Verbinden der Strings dienen.
